# EUROPÄISCHE PATENTSCHRIFT

(11) **EP 2 617 271 B1**
(45) Veröffentlichungstag und Bekanntmachung des Hinweises auf die Patenterteilung: **14.05.2014**
(21) Anmeldenummer: 11758162.9
(22) Anmeldetag: 05.09.2011
(51) Int. Cl.: H05K 3/12, H05K 3/28, H05K 1/03, H05K 3/46, H05K 3/14

(54) **ELEKTRONIKBAUTEIL MIT VERBESSERTER LEITUNGSSTRUKTUR**
ELECTRONIC COMPONENT WITH IMPROVED CONDUCTION STRUCTURE
COMPOSANT ÉLECTRONIQUE COMPRENANT UNE STRUCTURE DE CONDUCTION AMÉLIORÉE

(30) Priorität: 16.09.2010 DE 102010040867
(43) Veröffentlichungstag der Anmeldung: 24.07.2013
(73) Patentinhaber: Robert Bosch GmbH, 70442 Stuttgart (DE)
(72) Erfinder: WAHL, Ruben, 71394 Kernen (DE); KUGLER, Andreas, 73553 Alfdorf (DE); KOYUNCU, Metin, 71394 Kernen (DE)
(86) Internationale Anmeldenummer: PCT/EP2011/065312
(87) Internationale Veröffentlichungsnummer: WO 2012/034889

(56) Entgegenhaltungen:
- EP-A1- 1 855 514
- US-A1- 2006 292 769

## Beschreibung

### Stand der Technik

Die vorliegende Erfindung betrifft ein Elektronikbauteil mit einer verbesserten Leitungsstruktur sowie ein Verfahren zur Herstellung des Elektronikbauteils.

Elektronikbauteile werden heutzutage galvanisch, z.B. als Leiterplatten oder MID's (Moulded Interconnected Devices) hergestellt. Hierbei werden Aufbauten mit mehreren Schichten und gegebenenfalls Durchkontaktierungen zur Entflechtung der Leiterbahnen eingesetzt. Weiterhin ist es bekannt, leitfähige Tinten zu verwenden. Hierbei hat sich herausgestellt, dass die leitfähige Tinte mit einer gewissen Dicke aufgebracht werden muss, um eine Haftung der leitfähigen Tinte auf einem Trägermaterial nach dem Trocknen zu erreichen.

EP 1855514 A1 offenbart ein Elektronikbauteil gemäß dem Oberbegriff des Anspruches 1 der vorliegenden Erfindung.

### Offenbarung der Erfindung

Das erfindungsgemäße Elektronikbauteil mit den Merkmalen des Anspruchs 1 weist demgegenüber den Vorteil auf, dass es möglich ist, eine leitfähige Leitungsstruktur mittels einer elektrisch leitfähigen Tinte bereitzustellen, welches sowohl eine elektrische Leitung ermöglicht, als auch eine ausreichende Haftung auf einem Trägermaterial aufweist. Dadurch kann eine weitere Miniaturisierung von Leitungsstrukturen für Elektronikbauteile erreicht werden. Ein weiterer großer Vorteil des erfindungsgemäßen Elektronikbauteils liegt darin, dass die leitfähige Tinte auf einem beliebigen Trägermaterial, auf welchem die leitfähige Tinte z.B. auch schlecht haftet, aufgebracht werden kann. Auch kann erfindungsgemäß auf haftende Zusätze in der leitfähigen Tinte verzichtet werden. Ferner ist es erfindungsgemäß möglich, dass auch Kreuzungen in einer Leitungsebene herstellbar sind. Dies wird erfindungsgemäß dadurch möglich, dass die leitfähige Leitungsstruktur mittels einer isolierenden Schicht abgedeckt ist. Die isolierende Schicht wird auf die Leitungsstruktur aufgebracht und kann die Leitungsstruktur optimal schützen. Ferner können auch Höhensprünge der Leitungsstrukturen, z.B. auf Chipoberflächen, geschützt werden. Auch können mehrere Leitungslagen übereinander realisiert werden, indem zuerst eine erste Leitungsbahn aufgebracht wird, dann eine erste isolierende Schicht über die erste Leitungsbahn aufgebracht wird und anschließend eine zweite Leitungsbahn, welche die erste Leitungsbahn kreuzt oder über dieser liegt, aufgebracht wird und anschließend eine weitere zweite isolierende Schicht aufgebracht wird. Dabei kann das erfindungsgemäße Elektronikbauteil insgesamt sehr kostengünstig hergestellt werden, da die elektrisch leitfähigen Tinten und auch die isolierende Schicht aufgespritzt werden kann.

Die Unteransprüche zeigen bevorzugte Weiterbildungen der Erfindung.

Um einen besonders guten Schutz der leitfähigen Leitungsstruktur zu erhalten, weist die isolierende Schicht vorzugsweise eine größere Breite als die Leitungsstruktur auf. Hierdurch werden auch Seitenbereiche der Leitungsstruktur von der isolierenden Schicht vollständig überdeckt. Besonders bevorzugt ist dabei ein Überstand der isolierenden Schicht über die Leitungsstruktur zu beiden Seiten der Leitungsstruktur gleich breit. Hierbei kann die isolierende Schicht eine Haftungsfunktion für die Leitungsstruktur übernehmen, so dass im Extremfall die mittels der leitfähigen Tinte erzeugte Leitungsstruktur sehr schlechte oder keine Haftungseigenschaften auf dem Trägermaterial aufweisen kann und die mechanische Haftung dann von der isolierenden Schicht übernommen wird.

Besonders bevorzugt ist das Trägermaterial ein flexibles Material. Bei derartigen flexiblen Materialien ist eine Haftung der leitfähigen Tinte auf dem Trägermaterial im Stand der Technik nicht zu realisieren, da beim Verformen des flexiblen Materials die aufgebrachte leitfähige Tinte abblättert. Erfindungsgemäß kann jedoch durch die Haftungsfunktion der isolierenden Schicht die mechanische Haftung in die isolierende Schicht übertragen werden, so dass auch bei flexiblen Materialien die Verwendung von Leitungsstrukturen aus leitfähigen Tinten möglich ist. Das flexible Trägermaterial ist vorzugsweise ein textiles Material oder ein Folienmaterial oder ein flexibles Keramik-, Glas- oder Kunststoff-Substrat. Um eine Miniaturisierung des Elektronikbauteils zu ermöglichen, weist die leitfähige Leitungsstruktur vorzugsweise eine Dicke von kleiner oder gleich 100 µm auf. Eine Breite der Leitungsstruktur ist vorzugsweise größer oder gleich 10 µm.

Weiter bevorzugt dringt die isolierende Schicht teilweise in die leitfähige Leitungsstruktur ein. Hierdurch wird eine besonders gute Verankerung der isolierenden Schicht auf der Leitungsstruktur erreicht. Dies kann beispielsweise durch eine Oberflächenbehandlung der Leitungsstruktur vor dem Aufbringen der isolierenden Schicht, z.B. durch Ansintern mittels eines Lasers, erreicht werden.

Für einen möglichst kompakten Aufbau ist vorzugsweise eine Dicke der isolierenden Schicht kleiner als eine Dicke der leitfähigen Leitungsstruktur.

Das erfindungsgemäße Verfahren zur Herstellung eines Elektronikbauteils umfasst die Schritte des Bereitstellens eines nicht-leitenden Trägermaterials, des Aufbringens einer leitfähigen Leitungsstruktur aus einer leitfähigen Tinte auf das Trägermaterial und des Aufbringens einer isolierenden Schicht auf die Leitungsstruktur. Die Tinte wird vorzugsweise mittels eines Sprüh-Verfahrens aufgebracht. Vorzugsweise wird auch die isolierende Schicht mittels eines Sprüh-Verfahrens aufgebracht. Die isolierende Schicht kann dabei lediglich auf der Oberfläche der Leitungsstruktur aufgebracht werden oder bevorzugt mit einer größeren Breite als die Leitungsstruktur über die Leitungsstruktur aufgebracht werden, um zusätzlich noch eine Haftung zwischen der isolierenden Schicht und dem Trägermaterial aufzuweisen. Weiterhin kann bei dem erfindungsgemäßen Verfahren vor dem Aufbringen der isolierenden Schicht noch ein Ansintern der leitenden Leitungsstrukturen ausgeführt werden, um eine bessere Verankerung der isolierenden Schicht auf der Oberfläche der Leitungsstruktur zu erhalten. Das Ansintern kann beispielsweise mittels eines Lasers ausgeführt werden.

Die vorliegende Erfindung wird vorzugsweise im Fahrzeugbereich bei flexiblen Schaltungen, beispielsweise bei flexiblen Verdecken von Cabrios, oder der Integration von Elektronikbauteilen in Textilien, verwendet.

### Zeichnung

Nachfolgend wird ein Ausführungsbeispiel der Erfindung unter Bezugnahme auf die begleitende Zeichnung im Detail beschrieben. In der Zeichnung ist:
- Figur 1 bis 3: Darstellungen, welche die Herstellung des erfindungsgemäßen Elektronikbauteils zeigen, und
- Figur 4: eine schematische Schnittansicht durch das erfindungsgemäße Elektronikbauteil.

### Bevorzugte Ausführungsform der Erfindung

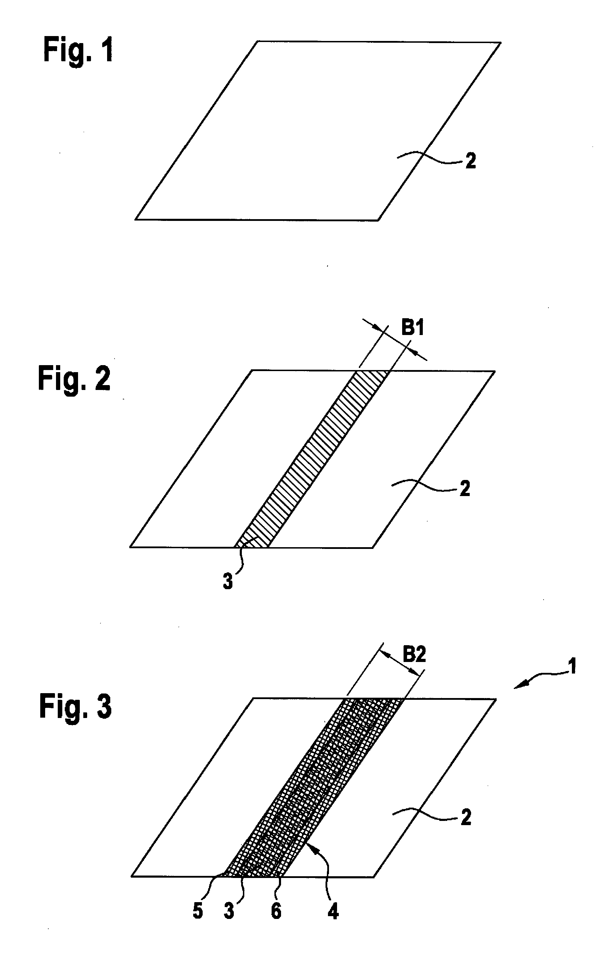

Nachfolgend wird unter Bezugnahme auf die Figuren 1 bis 4 ein Elektronikbauteil 1 gemäß einem bevorzugten Ausführungsbeispiel der Erfindung im Detail beschrieben.

Wie aus Figur 3 ersichtlich ist, umfasst das Elektronikbauteil 1 ein nicht- leitendes Trägermaterial 2, welches vorzugsweise ein flexibles Trägermaterial ist. Auf dem Trägermaterial 2 ist eine leitfähige Leitungsstruktur 3 aus leitfähiger Tinte aufgebracht (siehe Figur 2). Die leitfähige Tinte kann dabei mittels eines Sprüh-Verfahrens aufgespritzt werden. Die aufgespritzte Tinte bildet somit eine elektrisch leitfähige Leiterbahn auf dem Trägermaterial 2. Die Leitungsstruktur 3 weist dabei eine Breite B1 auf.

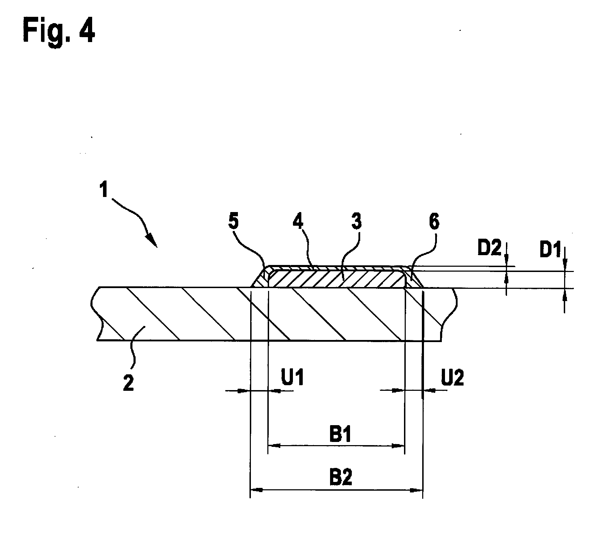

In einem nächsten Schritt wird eine isolierende Schicht, vorzugsweise aus einem Polymermaterial, aufgebracht. Dies kann ebenfalls mittels eines Aufspritzverfahrens erfolgen. Die isolierende Schicht 4 wird über die leitfähige Leitungsstruktur 3 aufgebracht. Dabei überdeckt die isolierende Schicht 4 die leitfähige Leitungsstruktur 3 vollständig. Ferner weist die isolierende Schicht 4 einen ersten Überstand 5 und einen zweiten Überstand 6 über die Breite B1 der Leitungsstruktur 3 auf. Somit weist die isolierende Schicht 4 eine Breite B2 auf (vgl. Figur 3 und 4), welche größer ist als eine Breite B1 der Leitungsstruktur 3.

Wie aus Figur 4 ersichtlich ist, ist eine Breite U1 des ersten Überstands 5 gleich groß wie eine Breite U2 des zweiten Überstands 6. Dies wird durch ein symmetrisches Aufbringen der isolierenden Schicht auf die Leitungsstruktur 3 ausgeführt. Dabei übernimmt die isolierende Schicht 4 insbesondere eine Haftungsfunktion auf dem Trägermaterial 2 und hält dadurch auch die leitfähige Leitungsstruktur 3. Selbst wenn eine Haftung der leitfähigen Leitungsstruktur 3 auf dem Trägermaterial 2 nicht optimal sein sollte, kann die Leitungsstruktur trotzdem mittels der isolierenden Schicht 4 fest auf dem Trägermaterial 2 in ihrer Position gehalten werden. Das Material der isolierenden Schicht 4 wird dabei vorzugsweise derart gewählt, dass es neben der isolierenden Eigenschaft auch eine sehr gute Haftungseigenschaft auf dem Trägermaterial 2 aufweist.

Wie weiter aus Figur 4 ersichtlich ist, weist die Leitungsstruktur 3 eine Dicke D1 auf, welche größer ist als eine Dicke D2 der auf der Leitungsstruktur aufgebrachten isolierenden Schicht 4. Die Dicke der isolierenden Schicht 4 muss dabei auf der Leitungsstruktur 3 nur derart ausgeführt sein, dass eine ausreichende Isolierung der Leitungsstruktur 3 sichergestellt wird.

Für eine bessere Haftung der isolierenden Schicht 4 auf der Oberfläche der Leitungsstruktur 3 wird die Leitungsstruktur 3 bei dem Aufbringen der isolierten Schicht mittels eines Lasers angesintert, nachdem eine ausreichende Trocknung der aufgespritzten Leitungsstruktur 3 vorliegt.

Somit übernimmt erfindungsgemäß die leitfähige Leitungsstruktur 3 die elektrisch leitfähige Funktion und die isolierende Schicht 4 übernimmt neben der Isolationsfunktion auch noch eine Fixierungsfunktion der Leitungsstruktur 3. Dadurch kann die Leitungsstruktur 3 eine sehr geringe Dicke D1 von kleiner oder gleich 100 µm aufweisen. Ferner kann die Leitungsstruktur 3 auch eine reduzierte Breite B1 aufweisen. Somit ist durch die vorliegende Erfindung eine weitere Miniaturisierung der Leitungsstrukturen auf Elektronikbauteilen möglich. Ferner können erfindungsgemäß auch einfach Kreuzungen von Leitungsbahnen bzw. Übereinanderanordnung von Leitungsbahnen ausgeführt werden, ohne dass hierbei eine zu große Dicke der Leitungsbahnen, ausgehend von einer Oberfläche des Trägermaterials 2 aufgebaut wird. An die derart erzeugten Leiterbahnen können dann gegebenenfalls elektronische Bauteile, z.B. Mikrochips usw., in bekannter Weise ankontaktiert werden. Auch ermöglicht die Erfindung die Verwendung von leitfähiger Tinte ohne Haftungszusätze.

Das erfindungsgemäße Verfahren ermöglicht somit ein Aufsprühen von Leiterbahnen aus leitfähiger Tinte, was sehr kostengünstig realisiert werden kann. Darüber hinaus können die Leiterbahnen auch auf flexible Trägermaterialien aufgebracht werden. Dabei ist erfindungsgemäß ein zweistufiges Verfahren vorgesehen, bei dem zuerst die leitfähige Tinte aufgebracht wird und anschließend die isolierende Schicht 4 über die leitfähige Leitungsstruktur aufgebracht wird. Da die isolierende Schicht 4 dabei ebenfalls aufgespritzt werden kann, ist ein Herstellungsprozess sehr einfach und schnell durchführbar.

Besonders bevorzugt ist die elektrisch leitfähige Leitungsstruktur aus einer harzfreien, leitfähigen Tinte hergestellt. Diese Tinte enthält vorzugsweise ausschließlich elektrisch leitfähige Partikel, z.B. Silber, und ein Lösungsmittel, welches nach dem Auftragen auf das Trägermaterial verdampft. Aufgrund der Harzfreiheit sind die Haftungseigenschaften derartiger Tinten auf dem Trägermaterial, insbesondere auf flexiblem Trägermaterial, unzureichend, so dass erfindungsgemäß mittels der isolierenden Schicht die Haftung der Tinte auf dem Trägermaterial sichergestellt werden kann.

## Patentansprüche

1. Elektronikbauteil, umfassend:
- ein Trägermaterial (2), wobei das Trägermaterial (2) elektrisch nichtleitende Eigenschaften aufweist,
- eine elektrisch leitfähige Leitungsstruktur (3), welche auf das Trägermaterial (2) aufgebracht ist, wobei die Leitungsstruktur (3) aus elektrisch leitfähiger Tinte hergestellt ist, und
- eine isolierende Schicht (4), welche auf die Leitungsstruktur (3) aufgebracht ist,
**dadurch gekennzeichnet, dass** eine Oberfläche der elektrisch leitfähigen Leitungsstruktur (3) angesintert ist.

2. Elektronikbauteil nach Anspruch 1, **dadurch gekennzeichnet, dass** eine Breite (B2) der isolierenden Schicht (4) größer ist als die Breite (B1) der Leitungsstruktur (3).

3. Elektronikbauteil nach Anspruch 2, **dadurch gekennzeichnet, dass** ein Überstand (5, 6) der isolierenden Schicht (4) über die Leitungsstruktur (3) zu beiden Seiten der Leitungsstruktur (3) eine gleiche Breite (U1, U2) aufweist.

4. Elektronikbauteil nach einem der vorhergehenden Ansprüche, **dadurch gekennzeichnet, dass** das Trägermaterial (2) ein flexibles Material, insbesondere ein Textilmaterial oder ein Folienmaterial oder ein flexibles Substrat ist.

5. Elektronikbauteil nach einem der vorhergehenden Ansprüche, **dadurch gekennzeichnet, dass** die Leitungsstruktur (3) eine Dicke (D1) von kleiner oder gleich 100 µm aufweist.

6. Elektronikbauteil nach einem der vorhergehenden Ansprüche, **dadurch gekennzeichnet, dass** die Leitungsstruktur (3) schlecht oder gar nicht auf dem Trägermaterial (2) haftet.

7. Elektronikbauteil nach einem der vorhergehenden Ansprüche, **dadurch gekennzeichnet, dass** die isolierende Schicht (4) in eine Oberfläche der Leitungsstruktur (3) teilweise eindringt.

8. Elektronikbauteil nach einem der vorhergehenden Ansprüche, **dadurch gekennzeichnet, dass** eine Dicke (D2) der isolierenden Schicht (4) kleiner ist als eine Dicke (D1) der Leitungsstruktur (3).

9. Elektronikbauteil nach einem der vorhergehenden Ansprüche, **dadurch gekennzeichnet, dass** die leitfähige Tinte keine Haftungszusätze aufweist.

10. Verfahren zur Herstellung eines Elektronikbauteil (1), umfassend die Schritte:
- Bereitstellen eines Trägermaterials (2) aus einem nicht-leitenden Material,
- Aufbringen einer elektrisch leitfähigen Leitungsstruktur (3) aus elektrisch leitfähiger Tinte auf das Trägermaterial (2), und
- Aufbringen einer isolierenden Schicht (4) auf die Leitungsstruktur (3), **dadurch gekennzeichnet, dass** die Oberfläche der Leitungsstruktur (3) vor dem Aufbringen der isolierenden Schicht angesintert wird.

## Claims

1. Electronic component, comprising:
- a carrier material (2), the carrier material (2) having electrically non-conducting properties,
- an electrically conductive conduction structure (3), which has been applied to the carrier material (2), the conduction structure (3) having been produced from electrically conductive ink, and
- an insulating layer (4), which has been applied to the conduction structure (3),
**characterized in that** a surface of the electrically conductive conduction structure (3) has been partially sintered.

2. Electronic component according to Claim 1, **characterized in that** a width (B2) of the insulating layer (4) is greater than the width (B1) of the conduction structure (3).

3. Electronic component according to Claim 2, **characterized in that** an overhang (5, 6) of the insulating layer (4) beyond the conduction structure (3) on both sides of the conduction structure (3) has an equal width (U1, U2).

4. Electronic component according to one of the preceding claims, **characterized in that** the carrier material (2) is a flexible material, in particular a textile material or a film material or a flexible substrate.

5. Electronic component according to one of the preceding claims, **characterized in that** the conduction structure (3) has a thickness (D1) of less than or equal to 100 µm.

6. Electronic component according to one of the preceding claims, **characterized in that** the conduction structure (3) adheres poorly or not at all to the carrier material (2).

7. Electronic component according to one of the preceding claims, **characterized in that** the insulating layer (4) partially penetrates into a surface of the conduction structure (3).

8. Electronic component according to one of the preceding claims, **characterized in that** a thickness (D2) of the insulating layer (4) is less than a thickness (D1) of the conduction structure (3).

9. Electronic component according to one of the preceding claims, **characterized in that** the conductive ink has no adhesion additives.

10. Method for producing an electronic component (1), comprising the steps of:
- providing a carrier material (2) of a non-conducting material,
- applying an electrically conductive conduction structure (3) of electrically conductive ink to the carrier material (2), and
- applying an insulating layer (4) to the conduction structure (3),
**characterized in that** the surface of the conduction structure (3) is partially sintered before the application of the insulating layer.

## Revendications

1. Composant électronique comprenant :
un matériau de support (2), le matériau de support (2) présentant des propriétés de non-conduction électrique,
une structure électriquement conductrice (3) appliquée sur le matériau de support (2), la structure conductrice (3) étant réalisée à partir d'une encre électriquement conductrice et
une couche isolante (4) appliquée sur la structure conductrice (3),
**caractérisé en ce que**
une surface de la structure électriquement conductrice (3) est frittée.

2. Composant électronique selon la revendication 1, **caractérisé en ce que** la largeur (B2) de la couche isolante (4) est supérieure à la largeur (B1) de la structure conductrice (3).

3. Composant électronique selon la revendication 2, **caractérisé en ce qu'**un débord (5, 6) de la couche isolante (4) au-delà de la structure conductrice (3) présente la même largeur (U1, U2) des deux côtés de la structure conductrice (3).

4. Composant électronique selon l'une des revendications précédentes, **caractérisé en ce que** le matériau de support (2) est un matériau flexible, en particulier un matériau textile, un matériau en feuille ou un substrat flexible.

5. Composant électronique selon l'une des revendications précédentes, **caractérisé en ce que** la structure conductrice (3) présente une épaisseur (D1) inférieure ou égale à 100 µm.

6. Composant électronique selon l'une des revendications précédentes, **caractérisé en ce que** la structure conductrice (3) adhère mal ou n'adhère même pas au matériau de support (2).

7. Composant électronique selon l'une des revendications précédentes, **caractérisé en ce que** la couche isolante (4) pénètre en partie dans une surface de la structure conductrice (3).

8. Composant électronique selon l'une des revendications précédentes, **caractérisé en ce que** l'épaisseur (D2) de la couche isolante (4) est inférieure à l'épaisseur (D1) de la structure conductrice (3).

9. Composant électronique selon l'une des revendications précédentes, **caractérisé en ce que** l'encre conductrice ne présente pas d'additif d'adhérence.

10. Procédé de fabrication d'un composant électronique (1), le procédé comportant les étapes qui consistent à :
préparer un matériau de support (2) en un matériau non conducteur,
appliquer sur le matériau de support (2) une structure électriquement conductrice (3) en encre électriquement conductrice et
appliquer sur la structure conductrice (3) une couche isolante (4),
**caractérisé en ce que**
la surface de la structure conductrice (3) est frittée avant l'application de la couche isolante.
